Europäisches Patentamt

European Patent Office

Office européen des brevets

(19)

(11) Veröffentlichungsnummer: **0 286 854**
**A1**

## (12) EUROPÄISCHE PATENTANMELDUNG

(21) Anmeldenummer: 88104152.9

(22) Anmeldetag: 16.03.88

(51) Int. Cl.⁴ **H01L 21/48 , H01L 23/48**

(30) Priorität: 13.04.87 CH 1418/87

(43) Veröffentlichungstag der Anmeldung:
19.10.88 Patentblatt 88/42

(84) Benannte Vertragsstaaten:
**CH DE FR GB LI SE**

(71) Anmelder: **BBC Brown Boveri AG**
**Haselstrasse**
**CH-5401 Baden(CH)**

(72) Erfinder: **Ackermann, Karl-Peter, Dr.**
**Gwiggweg 36**
**CH-5443 Niederrohrdorf(CH)**
Erfinder: **Hug, Rolf**
**Steinäckerstrasse 16A**
**CH-5442 Fislisbach(CH)**

(54) **Verfahren zum Herstellen einer mehrlagigen Dünnschichstschaltung.**

(57) Bei einem Verfahren zur Herstellung mehrlagiger Dünnschichtschaltungen, bei dem wenigstens zwei Metallisierungsebenen durch eine dicke Isolierschicht (5) aus negativ-photosensitivem Polyimid getrennt sind, wird zur Vermeidung von Unregelmässigkeiten bei den Durchkontaktierungsfenstern die auf den Einfluss des Keramiksubstrats (1) während der Belichtung zurückzuführen sind, vor dem Aufbringen des Polyimids die Oberfläche des Keramiksubstrats (1) mit einer Zwischenschicht (2) abgedeckt.

FIG.1E

EP 0 286 854 A1

## Verfahren zum Herstellen einer mehrlagigen Dünnschichtschaltung

Technisches Gebiet

Die Erfindung bezieht sich auf das Gebiet der Mikroeletronik. Sie betrifft insbesondere ein Verfahren zum Herstellung einer mehrlagigen Dünnschichtschaltung, bei welchem Verfahren
- auf ein Keramiksubstrat in einer ersten Metallisierungsebene erste Leiterbahnen aufgebracht werden:
- die ersten Leiterbahnen anschliessend mit einer Isolierschicht aus einem negativ-photosensitiven Material überdeckt werden:
- die Isolierschicht durch eine Photomaske hindurch belichtet und danach entwickelt wird: wobei
- die Photomaske derart ausgestaltet ist, dass in die Isolierschicht im Bereich der ersten Leiterbahnen Durchkontaktierungsfenster eingebracht werden: und
- in einer zweiten Metallisierungsebene auf die Isolierschicht zweite Leiterbahnen aufgebracht werden, welche in den Bereichen der Durchkontaktierungsfenster über den ersten Leiterbahnen verlaufen und diese durch die Durchkontaktierungsfenster hindurch kontaktieren.

Stand der Technik

Die zunehmende Miniaturisierung und Integration in der Mikroelektronik. wie sie in den komplexen hochintegrierten VLSI-Schaltungen (VLSI = Very Large Scale Integration) augenfällige zum Ausdruck kommt, erfordert wegen der steigenden Anzahl von Ein-und Ausgängen pro IC neue Technologien des Schaltungsaufbaus und der Verbindungen zwischen einzelnen ICs, um das mit den modernen Schaltkreisen gegebene Verkleinerungspotential möglichst weitgehend ausnutzen zu können.

Aus diesem Grunde ist vorgeschlagen worden (siehe z.B. K.P. Ackermann et al., Proc. Int. Symp. on Microelectronics 1986 ISHM. Atlanta, Georgia, USA. S. 519-524), mehrere hochintegrierte Schaltkreise zusammen mit weiteren externen Bauelementen in hybriden Dünnschichtschaltungen zusammenzufassen, die sich durch eine mehrlagige Leiterstruktur bei reduzierter Leiterbahnbreite auszeichnen.

Bei dieser bekannten Mehrlagen-Dünnschichttechnologie werden auf einenm Keramiksubstrat auf wenigstens zwei übereinanderliegenden Metallisierungsebenen Leiterbahnen angeordnet. Die Metallisierungsebenen sind durch eine dazwischenliegende Isolierschicht voneinander getrennt.

Die Leiterbahnen der unterschiedlichen Ebenen überkreuzen sich teilweise. Für eine Durchkontaktierung zwischen beiden Metallisierungsebenen sind in der Isolierschicht Durchkontaktierungsfenster (sog. "via-holes") freigelassen. durch welche eine obenliegende mit einer darunterliegenden Leiterbahn jeweils in Kontakt steht.

Eine ähnliche Mehrlagen-Technik ist auch bei den ICs selbst bekannt (siehe z.B. EP-A2 0 122 078).

Als Material für die Isolierschicht zwischen aufeinanderfolgenden Metallisierungsebenen hat sich Polyimid als besonders günstig erwiesen. weil es sich gut in die Prozesse der Dünnfilmtechnologie einfügt.

Das Polyimid kann z.B. in einer flüssigen Vorform wie ein Photoresist aufgeschleudert und in einem teilweise verfestigten Zustand strukturiert werden. Es hat gute Ausgleichseigenschaften und erlaubt eine hohe Auflösung bei der Strukturierung der Durchkontaktierungsfenster.

Der herkömmliche Prozess zur Herstellung mehrlagiger Schaltungen umfasst die folgenden Schritte:
- In einer ersten Metallisierungsebene werden in bekannter Weise erste Leiterbahnen und Widerstände auf ein Substrat aufgebracht;
- darüber wird ein Polymid-Film in flüssiger Vorform (precursor) aufgeschleudert (spin coating) und einer Wärmebehandlung (softbake) unterzogen; als Polyimid wird dabei ein nicht photosensitives Polyimid verwendet;
- über den Polyimid-Film wird ein Photoresist aufgeschleudert und einer Wärmebehandlung unterzogen;
- die Photoresist-Schicht wird durch eine Photomaske mit dem Muster der Durchkontaktierungsfenster belichtet;
- der Photoresist wird entwickelt und gleichzeitig zusammen mit dem Polyimid nasschemisch geätzt:
- der Photoresist wird entfernt;
- das Polyimid wird bei 300-400°C ausgehärtet (imidisiert); und
- in einer zweiten Metallisierungsbene werden zweite Leiterbahnen auf das Polyimid aufgebracht, wobei dieselben Prozesse verwendet werden wie beim ersten Schritt.

Anstelle der nasschemischen kann auch eine Plasma-oder Laser-Aetzung treten Darüberhinaus ist es möglich, ein UV-empfindliches negativ-photosensitives Polyimid zu verwenden. sodass auf den Einsatz von Photoresist verzichtet werden kann.

Für Anwendungen in hybriden Dünnschichtschaltungen werden an die Isolierschicht. d.h. die Polyimid-Schicht, besondere Anforderungen gestellt:

- Kleiner Uebergangswiderstand zwischen durchkontaktierten Leiterbahnen;
- der Polyimid-Film soll blasenfrei sein;
- es dürfen keine ungewollten Kurzschlüsse zwischen den Metallisierungsebenen entstehen;
- die dielektrische Festigkeit muss mehrere 100 V betragen; und
- die Zuverlässigkeit muss insgesamt sehr hoch sein.

Während der übliche Polyimid-Strukturierungs-Prozess, wie er bei IC-Anwendungen eingesetzt wird (EP-A2 0 122 078), mit Schichtdicken von weniger als 2 $\mu$m arbeitet, werden bei hybriden Dünnschichtschaltungen zur Erfüllung der o.g. Anforderungen Schichtdicken von mehr als 10 $\mu$m notwendig.

Wie in dem eingangs genannten Artikel von K.P. Ackermann et al. dargestellt, ergeben sich bei der Strukturierung von Schichten aus normalem, nicht-photosensitiven Polyimid bei Dicken grösser als 5 $\mu$m jedoch Probleme, die sowohl beim nasschemischen als auch beim Plasma-Aetzen auftreten.

Eine Lösung dieser Probleme kann zwar mit dem Einstz von negativ-photosensitiven Polyimiden herbeigeführt werden. Dafür entstehen bei dieser Polyimid-Art aber neue Probleme, die auf den Einfluss des Keramiksubstrats bei der UV-Belichtung zurückzu führen sind, und sich darin äussern, dass die Durchkontaktierungsfenster beim Strukturieren nicht vollständig freigelegt werden, sondern am Rand z.B. ringförmige Polyimidreste aufweisen, die eine sichere Durchkontaktierung zumindest behindern.

Dabei hat sich herausgestellt, dass sowohl die Rauhigkeit der Substratoberfläche als auch die optischen Eigenschaften des Substrat-Bulkmaterials für diese Probleme eine entscheidende Rolle spielen.

Darstellung der Erfindung

Aufgabe der vorliegenden Erfindung ist es nun, das Verfahren zur Herstellung von mehrlagigen Dünnschichtschaltungen so zu gestalten, dass selbst bei grossen Dicken der Isolierschicht die Durchkontaktierungsfenster sicher und definiert strukturiert werden können.

Die Aufgabe wird bei einem Verfahren der eingangs genannten Art dadurch gelöst, dass das Keramiksubstrat vor dem Aufbringen der Isolierschicht ganzflächig mit einer Zwischenschicht bedeckt wird.

Der Kern der Erfindung besteht darin, den negativen Einfluss des Substrats beim Belichten der Polyimid-Isolierschicht durch das Zwischenschalten einer in den Oberflächen-und Bulkeigenschaften frei wählbaren Zwischenschicht herabzusetzen bzw. ganz auszuschalten.

Ausführungsbeispiele und Ausgestaltungen der Erfindung ergeben sich aus den Unteransprüchen.

Kurze Beschreibung der Zeichnung

Die Erfindung soll nachfolgend im Zusammenhand mit der Zeichnung anhand von Ausführungsbeispielen näher erläutert werden. Es zeigen:

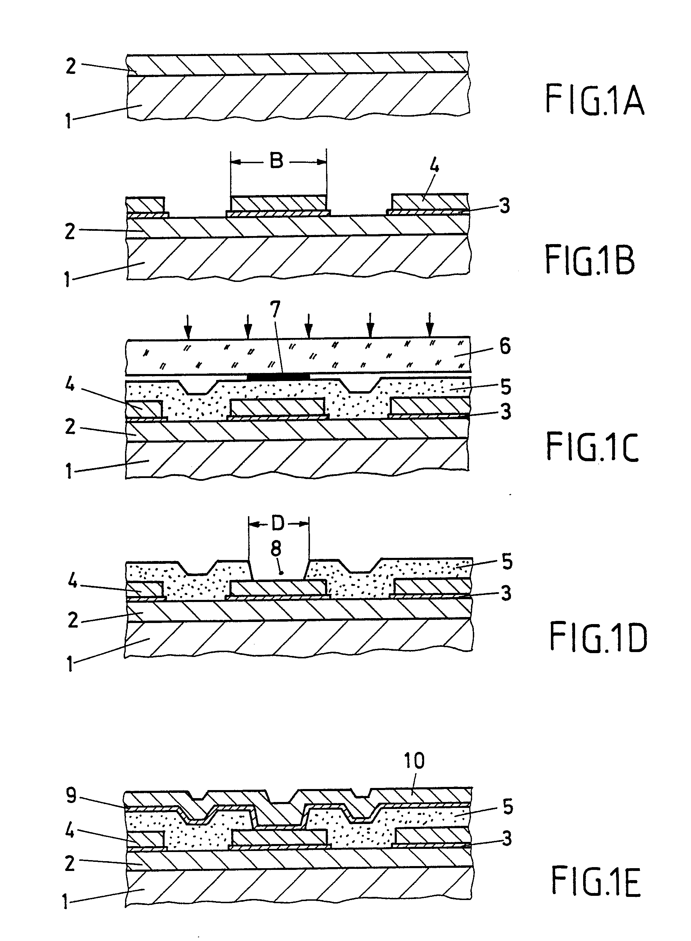

Fig.1A-E verschiedene Fertigungsstufen bei der Herstellung einer mehrlagigen Dünnschichtschaltung gemäss einem bevorzugten Ausführungsbeispiel des erfindungsgemässen Verfahrens.

Wege zur Ausführung der Erfindung

Für ein bevorzugtes Ausführungsbeispiel des erfindungsgemässen Verfahrens sind verschiedene Fertigungsstufen bzw. Zwischenstadien einer Dünnschichtschaltung in der Fig. 1A-E dargestellt.

Ausgegangen wird von einem Keramiksubstrat 1 (Fig. 1A) mit planer Oberfläche, welches vorzugsweise aus einer Al$_2$O$_3$-Keramik besteht. Auf dieses Keramiksubstrat 1, das den in der Halbleitertechnik und Mikroeletronik üblichen Reinigungsprozessen unterworfen worden ist, wird zunächst ganzflächig eine dünne Zwischenschicht 2 aufgebracht.

Es hat sich als besonders günstig herausgestellt, für den Aufbau der Zwischenschicht 2 ein Polyimid, insbesondere ein preiswertes nicht-photosensitives Polyimid (z.B. das Polyimid Pyraline 2550 der Firma Du Pont) zu verwenden, weil ein solches Polyimid vom Auftragprozess her gut in die Dünnschichttechnologie eingepasst und auf einfache Weise in einer flüssigen Vorform durch Aufschleudern (spin-coating) aufgetragen und anschliessend verfestigt werden kann.

Mit einem solchen Polyimid wird nun die Zwischenschicht 2 erzeugt, welche eine Dicke von weniger als 10 $\mu$m, vorzugsweise kleiner 5 $\mu$m, aufweist. Eine Dicke in dieser Grössenordnung gewährleistet eine entsprechende thermische Ankopplung darüberliegender Schichten an das Keramiksubstrat.

Nachdem auf die genannte Art das Keramiksubstrat 1 vollständig mit der Zwischenschicht 2 bedeckt worden ist, werden in an sich bekannter Weise auf der Zwischenschicht 2 in einer ersten Metallisierungsebene erste Leiterbahnen 4 aufgebaut (Fig. 1B).

Dazu wird zunächst einer erste Schichtfolge 3, bestehend aus etwa 10-20 nm NiCr und 100-500 nm Cu oder Ni durch Aufsputtern erzeugt. Auf die erste Schichtfolge 3 wird eine Photolackschicht aufgebracht und photolithographisch mit dem Bild der ersten Leiterbahnen 4 strukturiert. Die ersten Leiterbahnen 4 selbst werden dann als Schichtfolge aus je etwa 3 μm Ni und Au durch Elektroplattieren in den Oeffnungen der Photolackschicht abgeschieden.

Die Photolackschicht wird schliesslich entfernt und die erste Schichtfolge 3 zwischen den ersten Leiterbahnen 4 weggeätzt (falls Dünnschichtwiderstände erzeugt werden sollen, ist ein weiterer photolithographischer Strukturierungsprozess für die erste Schichtfolge 3 notwendig).

Die Breite B der ersten Leiterbahnen 4 ist kleiner als 100 μm, z.B. etwa 75 μm, die Abstände zwischen den ersten Leiterbahnen liegen bei etwa 50 μm.

Nachdem die erste Metallisierungsebene mit den ersten Leiterbahnen 4 und gegebenenfalls mit entsprechenden, in Fig. 1B nicht dargestellten Dünnschichtwiderständen fertiggestellt ist, wird das ganze Substrat mit einer Isolierschicht 5 aus negativ-photosensitivem Polyimid bedeckt (Fig. 1C).

Da die Isolierschicht 5 die verschiedenen Metallisierungsebenen, abgesehen von den gewollten Durchkontaktierungen, zuverlässig elektrisch voneinander trennen soll, wird ihre Dicke vorzugsweise grösser 5 μm, insbesondere grösser 10 μm gewählt.

Als geeignete negativ-photosensitive Polyimide können z.B. die Produkte Photoneece UR-3100 der Firma Toray Industries Inc., Tokyo, oder Probimide 348 der Firma Ciba-Geigy, Schweiz, oder Selectilux HTR3 der Firma Merck, Darmstadt (BRD), verwendet werden.

Ein solches photosensitives Polyimid wird in seiner flüssigen Vorform (precursor), wiederum durch Aufschleudern, auf das mit Zwischenschicht 2 und ersten Leiterbahnen 4 bedeckte Keramiksubstrat 1 aufgebacht und dann mittels einer Wärmebehandlung getrocknet (sog. "softbake").

Zur Strukturierung der entstandenen Isolierschicht 5, d.h. zum Einbringen von Druckkontaktierungsfenstern (8 in Fig. 1D), wird das photosensitive Polyimid durch eine entsprechende Photomaske 6 mit UV-Strahlung belichtet (Pfeile in Fig. 1C).

Die Photomaske 6 besteht im wesentlichen aus einer Glasplatte, auf deren dem Polyimid zugewandten Seite das Strukturierungsmuster in Form einer UV-undurchlässigen Maskenschicht 7 aus Cr aufgebracht ist. Da die Polyimid negativ-photosensitiv sind, befindet sich die Maskenschicht 7 jeweils an den Stellen, an welchen das Polyimid aus der Isolierschicht 5 entfernt werden soll.

Bei der Belichtung bewirkt nun die Zwischenschicht 2, die das Keramiksubstrat 1 abdeckt, dass nur noch wenig Streulicht in den von der Maskenschicht 7 primär abgeschatteten Bereich des Polyimids der Isolierschicht 5 gelangt. Dies geschieht einerseits durch eine Schwächung der auf den rauhen und damit lichtstreuenden Untergrund (Keramiksubstrat 1) auftreffenden UV-Strahlung in der Zwischenschicht 2, und andererseits durch die Bereitstellung einer neuen, glatten und damit streuarmen Oberfläche (auf der Zwischenschicht 2 und den Leiterbahnen 4). Entsprechend führt die anschliessende Entwicklung und Strukturierung des belichteten Polyimids zu Durchkontaktierungsfenster 8 (Fig. 1D) mit eindeutig definierter Randgeometrie. Der Durchmesser D der näherungsweise runden Durchkontaktierungsfenster 8 ist, wie aus Fig. 1D entnommen werden kann, kleiner als die Breite B der ersten Leiterbahnen 4.

An die Entwicklung der Polyimidschicht und das Freilegen der Durchkontaktierungsfenster 8 schliesst sich eine zweite Wärmebehandlung bei 300-400°C an, bei der das Polyimid seine endgültige verfestigte Struktur erhält (Imidisations-Zyklus).

Es sei hinzugefügt, dass alle Prozessschritte, die mit dem Aufbringen, Belichten und Entwickeln des photosensitiven Polyimids zusammenhängen, je nach Art des verwendeten Polyimids unterschiedlich ausgestaltet sein können.

Auf die Isolierschicht 5 werden dann in einer zweiten Metalliesierungsebene zweite Leiterbahnen 10 (Fig. 1E) mit einer zweiten Schichtfolge 9 in gleicher Weise aufgebracht wie in der ersten Metallisierungsebenen. An den Stellen der Durchkontaktierungsfenster reichen die zweiten Leiterbahnen 10 dann hinab bis in die erste Metallisierungsebene und kontaktieren die entsprechenden ersten Leiterbahnen 4.

Obwohl sich das gezeigte Ausführungsbeispiel auf eine nur zweilagige Dünnschichtschaltung bezieht, ist die Erfindung auf Schaltungen mit beliebiger Lagenzahl anwendbar.

Insgesamt steht mit der Erfindung ein Verfahren zur Verfügung, mit dem zuverlässige hybride mehrlagige Dünnschichtschaltungen hergestellt werden können.

## Ansprüche

1. Verfahren zum Herstellen einer mehrlagigen Dünnschichtschaltung, bei welchem Verfahren

(a) auf ein Keramiksubstrat (1) in einer ersten Metallisierungsebene erste Leiterbahnen (4) aufgebacht werden;

(b) die ersten Leiterbahnen (4) mit einer Isolierschicht (5) aus einem negativ-photosensitiven Material überdeckt werden;

(c) die Isolierschicht (5) durch eine Photomaske (6) hindurch belichtet und danach entwickelt wird;

(d) die Photomaske derart ausgestaltet ist, dass in die Isolierschicht (5) im Bereich der ersten Leiterbahnen (4) Durchkontaktierungsfenster (8) eingebracht werden; und

(e) in einer zweiten Metallisierungsebene auf die Isolierschicht (5) zweite Leiterbahnen (10) aufgebracht werden, welche in den Bereichen der Durchkontaktierungsfenster (8) über den ersten Leiterbahnen (4) verlaufen und diese durch die Durchkontaktierungsfenster (8) hindurch kontaktieren; dadurch gekennzeichnet, dass

(f) das Keramiksubstrat (1) unter der ersten Metallisierungsebene ganzflächig mit einer Zwischenschicht (2) bedeckt wird.

2. Verfahren nach Anspruch 1, dadurch gekennzeichnet, dass die Isolierschicht (5) aus einem negativ-photosensitiven Polyimid besteht, und das Polyimid der Isolierschicht (5) in flüssiger Vorform durch Aufschleudern (spin-coating) aufge tragen und nach dem Entwickeln durch eine Wärmebehandlung in ein Polyimid umgewandelt wird.

3. Verfahren nach Anspruch 2, dadurch gekennzeichnet, dass das Keramiksubstrate (1) aus einer $Al_2O_3$-Keramik besteht.

4. Verfahren nach Anspruch 3, dadurch gekennzeichnet, dass die Zwischenschicht (2) aus einem Polyimid, vorzugsweise einem nicht-photosensitiven Polyimid, besteht.

5. Verfahren nach Anspruch 4, dadurch gekennzeichnet, dass das Polyimid der Zwischenschicht (2) in flüssiger Vorform durch Aufschleudern (spin-coating) aufgetragen und anschliessend durch eine Wärmebehandlung verfestigt wird.

6. Verfahren nach Anspruch 5, dadurch gekennzeichnet, dass die Zwischenschicht (2) eine Dicke kleiner 10 μm, vorzugsweise kleiner 5 μm, aufweist.

7. Verfahren nach Anspruch 1, dadurch gekennzeichnet, dass die Isolierschicht (5) eine Dicke von mehr als 5 μm, vorzugsweise mehr als 10 μm, aufweist.

8. Verfahren nach Anspruch 1, dadurch gekennzeichnet, dass als Photomaske (6) eine mit einer Maskenschicht (7), vorzugsweise aus Cr, beschichtete Glasplatte verwendet wird.

9. Verfahren nach Anspruch 1, dadurch gekennzeichnet, dass die Breite (B) der Leiterbahnen (4,10) kleiner als 100 μm ist, und der Durchmesser (D) der Durchkontaktierungsfenster (8) kleiner als die Breite (B) der Leiterbahnen (4,10) ist.

10. Verfahren nach Anspruch 1, dadurch gekennzeichnet, dass die Leiterbahnen (4,10) eine Schichtfolge aus Ni und Au umfassen, und auf Schichtfolgen (3,9) aus NiCr und Cu oder Ni aufplattiert werden.

FIG.1A

FIG.1B

FIG.1C

FIG.1D

FIG.1E

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | IBM TECHNICAL DISCLOSURE BULLETIN, Band 26, Nr. 10B, März 1984, Seiten 5378-5379, New York, US; R. ACOSTA et al.: "Planarization of copper circuits for multilevel ceramic package" * Insgesamt * | 1 | H 01 L 21/48<br>H 01 L 23/48 |
| A | IDEM<br>--- | 4,5 | |
| Y | EP-A-0 190 490 (GOULD) * Seite 5, Zeile 30 - Seite 6, Zeile 6; Ansprüche 1,4,10; Seite 6, Zeilen 29-33; Seite 7, Zeilen 24-27; Seite 8, Zeilen 6-8 * | 1 | |
| A | <br>---<br> | 2,3,7, 10 | |
| A | IBM TECHNICAL DISCLOSURE BULLETIN, Band 21, Nr. 12, Mai 1979, Seite 4787, New York, US; O.R. ABOLAFIA: "Tapered vias in a photosensitive dielectric film"<br>--- | 2,8 | |
| A | IBM TECHNICAL DISCLOSURE BULLETIN, Band 8, Nr. 12, Mai 1966, Seite 1733, New York, US; H.L. CASWELL: "Electroforming film patterns for interconnections"<br>--- | 10 | RECHERCHIERTE SACHGEBIETE (Int. Cl.4)<br><br>H 01 L |
| A | FR-A-2 201 542 (BENDIX) * Anspruch 1 *<br>----- | 3,10 | |

Der vorliegende Recherchenbericht wurde für alle Patentansprüche erstellt

| Recherchenort | Abschlußdatum der Recherche | Prüfer |
|---|---|---|
| DEN HAAG | 08-06-1988 | DE RAEVE R.A.L. |